# FASCICULE DE BREVET EUROPEEN

(11) **EP 3 995 785 B1**
(45) Date de publication et mention de la délivrance du brevet: **16.10.2024**
(21) Numéro de dépôt: 21206608.8
(22) Date de dépôt: 05.11.2021
(51) Int. Cl.: G01K 17/06, G01F 1/684, G01F 15/06, G01R 22/10, G01D 4/00, F24D 17/00, F24D 19/10, F24H 9/20, G01D 11/30, G01F 9/00

(54) **SYSTÈME ET PROCÉDÉ D'ESTIMATION DE CONSOMMATION D'UN CHAUFFE-EAU ÉLECTRIQUE**
SYSTEM UND VERFAHREN ZUM SCHÄTZEN DES VERBRAUCHS EINES ELEKTRISCHEN WASSERBOILERS
SYSTEM AND METHOD FOR ESTIMATING CONSUMPTION OF AN ELECTRIC WATER HEATER

(30) Priorité: 05.11.2020 FR 2011351
(43) Date de publication de la demande: 11.05.2022
(73) Titulaire: Electricité de France, 75008 Paris (FR)
(72) Inventeur: BERNASCONI, Stéphane, 77810 THOMERY (FR); GASTIGER, Frédéric, 77210 AVON (FR); WISZNIEWSKI, David, 77670 SAINT MAMMES (FR); COINCE, Anne-Sophie, 77210 AVON (FR); TRAILIN, Jérôme, 77300 FONTAINEBLEAU (FR)
(74) Mandataire: Plasseraud IP

(56) Documents cités:
- EP-A1- 3 098 536
- US-A1- 2010 004 790
- US-A1- 2019 346 494
- ANONYMOUS: "MGL Avionics Magnetic current sensor For aircraft systems supply circuit current measurement", 30 December 2020 (2020-12-30), pages 1 - 13, XP055819502, Retrieved from the Internet <URL:https://web.archive.org/web/20201230020154if_/http://www.mglavionics.eu//lignes/mgl/pdf/Magnetic_current_monitor.pdf> [retrieved on 20210630]
- YUMPU.COM: "STRATOMASTER Instrumentation MGL Avionics", 1 January 2021 (2021-01-01), XP055819689, Retrieved from the Internet <URL:https://www.yumpu.com/en/document/view/43294469/stratomaster-instrumentation-mgl-avionics> [retrieved on 20210630]
- ANONYMOUS: "Guide pratique: Installer un compteur sans fil sur son vélo - 2021", 2018, XP055819506, Retrieved from the Internet <URL:https://compteur-gps-velo.fr/installer-compteur-velo/> [retrieved on 20210630]

## Description

### Domaine technique

Le domaine de l'invention se rapporte à l'estimation de la consommation d'un chauffe-eau électrique à accumulation, et notamment les consommations en énergie électrique et en eau.

### Technique antérieure

Aujourd'hui, la gestion des appareils électriques constitue une problématique centrale dans le domaine des économies d'énergie. En particulier, la production d'eau chaude sanitaire, énergétiquement très coûteuse, est un enjeu majeur dans le développement de la gestion et de la programmation des chauffe-eaux électriques, ou ballons d'eau chaude.

Ainsi, les chauffe-eaux électriques sont souvent pilotés par le gestionnaire du réseau de distribution électrique et leur fonctionnement est régulé au rythme des heures de la journée. Afin de réduire la charge des réseaux de distribution électrique durant les périodes dites d' « heure pleine » (HP), lorsque la demande est forte, typiquement en journée, la consommation de certains appareils peut être décalée dans le temps et repoussée à une période dite d' « heure creuse » (HC), typiquement la nuit. Grâce à l'inertie thermique de l'eau chaude, les ballons d'eau chaude se prêtent particulièrement bien à de tels décalages. Ce décalage dans le temps est peu ou pas sensible pour l'utilisateur : l'eau est chauffée en heures creuses et maintenue au-dessus d'une température seuil. Un tel fonctionnement d'une installation domestique est bénéfique à l'ensemble du réseau de distribution et est parfois, en outre, récompensé par l'application de tarif avantageux en heures creuses pour le consommateur.

Un tel fonctionnement est automatisé au moyen d'un contacteur jour/nuit (aussi appelé « contacteur HP/HC ») disposé en amont sur le circuit d'alimentation du chauffe-eau, généralement dans un tableau de répartition. Le contacteur est commandé au moyen d'un signal transmis via le réseau de distribution lui-même et sous la responsabilité du gestionnaire du réseau. Par souci d'apporter de la flexibilité au consommateur, ce dernier peut souhaiter déroger, au moins temporairement, à un tel fonctionnement et modifier lui-même le mode de fonctionnement du chauffe-eau électrique selon ses besoins. Dans le but d'éviter au consommateur d'avoir à intervenir sur le chauffe-eau électrique ou dans le tableau de répartition, des systèmes permettant au consommateur de modifier le mode de fonctionnement à distance se sont développés. Par exemple, les contacteurs jour/nuit usuels peuvent être remplacés par des contacteurs pilotables au moyen d'un téléphone intelligent (« smartphone »).

Par ailleurs, toujours dans un souci d'économie d'énergie, l'utilisateur peut avoir le souhait d'accéder au bilan de la consommation en énergie électrique et en eau chaude sanitaire d'un chauffe-eau électrique à accumulation.

Typiquement, l'estimation des consommations en énergie électrique et en eau chaude sanitaire peut être obtenue par l'installation, au niveau du ballon d'eau chaude, d'un compteur. Toutefois, une telle installation est complexe et nécessite donc l'intervention d'un professionnel. Par exemple, l'installation d'un débitmètre en entrée ou en sortie du ballon d'eau chaude requiert un savoir-faire en plomberie. De même, l'intervention d'un électricien est nécessaire pour l'installation d'un appareil de mesure du courant ou d'un compteur d'énergie au niveau de l'alimentation électrique du ballon d'eau chaude. Le document US2010/004790, intitulé « Water Heater Demand Side Management System », propose une telle solution, qui peut être adaptée sur des chauffe-eau existants. US2010/004790 décrit en particulier la détermination d'une consommation volumétrique d'eau qui se base sur une équation prenant en compte une consommation électrique mesurée par un capteur de courant, une température en sortie mesurée et une température en entrée qui peut être mesurée ou estimée.

Le document EP3098536A1, au nom du Demandeur, propose quant à lui un « Procédé d'estimation d'un profil de température d'un réservoir d'eau d'un chauffe-eau ».

### Résumé

La présente invention vient améliorer la situation.

A ce titre, la présente invention concerne un système défini par la revendication 1 d'estimation de consommation d'un chauffe-eau électrique à accumulation. Le système comprend :
- un capteur de température agencé pour mesurer la température au niveau d'un tuyau d'extraction d'eau chaude d'une cuve de stockage du chauffe-eau et apte à mesurer une variation de température provoquée par la circulation de l'eau chaude,
- un capteur de champ magnétique agencé pour mesurer une intensité du champ magnétique au niveau d'un câble d'alimentation électrique du chauffe-eau, et
- un circuit de traitement configuré pour détecter, en fonction des mesures du capteur de champ magnétique, une ou plusieurs périodes de chauffe du chauffe-eau, puis estimer, en fonction de la ou des périodes de chauffe détectées et de caractéristiques électriques du chauffe-eau, une consommation électrique du chauffe-eau sur une période de temps donnée, et détecter, en fonction des mesures du capteur de température, un ou plusieurs soutirages d'eau chaude du chauffe-eau, classifier le ou les soutirages d'eau chaude, en fonction d'une évolution temporelle des températures mesurées par le capteur de température entre le début et la fin du soutirage, puis estimer, en fonction du ou des soutirages d'eau chaude détectés et de la classe du ou des soutirages, une quantité d'eau chaude soutirée sur ladite période de temps.

Le positionnement du capteur de température directement sur le tuyau d'extraction d'eau chaude permet de détecter des soutirages d'eau chaude et de mesurer avec précision la durée des soutirages. De même, le positionnement du capteur de champ magnétique directement sur le câble d'alimentation électrique permet une détection efficace des périodes de chauffe du chauffe-eau électrique.

Dans un ou plusieurs modes de réalisation, le système comprend en outre un capteur de température supplémentaire agencé pour mesurer la température au niveau d'un tuyau d'alimentation en eau froide de la cuve de stockage du chauffe-eau. Le circuit de traitement est alors configuré pour estimer les consommations en énergie électrique et en eau du chauffe-eau en fonction en outre des mesures du capteur de température supplémentaire.

Habituellement, dans un chauffe-eau électrique à accumulation, la cuve est alimentée en eau froide en réponse à un soutirage d'eau chaude de manière à maintenir un volume total d'eau constant dans la cuve. Cette eau-froide est destinée à être chauffée lors de la prochaine période de chauffe qui correspond généralement à une période d'heure creuse. Par conséquent, le capteur de température supplémentaire agencé sur le tuyau d'alimentation en eau froide permet de détecter indirectement un soutirage d'eau chaude.

Typiquement, un ou plusieurs des capteurs sont configurés pour collecter des mesures à intervalles de temps réguliers.

Avantageusement, le système comprend en outre une mémoire configurée pour stocker les mesures collectées par les capteurs.

Dans un ou plusieurs modes de réalisation, le circuit de traitement est localisé au niveau d'un serveur distant et le système comprend en outre un module de communication configuré pour transmettre les mesures réalisées par les capteurs au circuit de traitement.

Dans un ou plusieurs modes de réalisation, le capteur de champ magnétique est logé dans un boîtier comprenant des moyens d'attache pour être fixé au câble d'alimentation électrique.

Par exemple, les moyens d'attache comprennent un collier de serrage autobloquant. Le boîtier présente alors:
- un trou traversant conformé et dimensionné pour autoriser le passage du collier de serrage autobloquant, le boîtier étant adapté pour être fixé au câble d'alimentation électrique par bouclage du collier de serrage autobloquant autour du câble d'alimentation électrique en passant par le trou traversant, ou
- au moins une portion faisant saillie du boîtier, le boîtier étant adapté pour être fixé au câble d'alimentation électrique par bouclage du collier de serrage autobloquant autour du câble d'alimentation électrique et de la portion.

Les moyens d'attache peuvent également comprendre un élastique. Le boîtier présente alors une ou plusieurs paires de crochets agencés sur des faces latérales opposées du boîtier. Le boîtier est adapté pour être fixé au câble d'alimentation électrique par rappel de l'élastique accroché au boîtier via la paire de crochets, le boîtier et l'élastique enserrant ainsi le câble d'alimentation électrique.

De tels moyens d'attache, avec un collier de serrage ou un élastique, présentent l'avantage de pouvoir s'adapter aux dimensions du câble d'alimentation électrique, que ce soit l'épaisseur ou la forme de la section du câble. Par ailleurs, ces moyens d'attache permettent de positionner facilement le capteur de champ magnétique de manière non-intrusive.

Dans un ou plusieurs modes de réalisation, le système comprend en outre un témoin visuel représentatif de l'intensité du champ magnétique mesurée par le capteur de champ magnétique.

Le témoin visuel permet de déterminer, pour le capteur de champ magnétique, un emplacement auquel l'intensité du champ magnétique généré par la circulation du courant électrique dans le câble d'alimentation électrique est suffisamment élevée pour être mesurée.

La présente invention concerne également un procédé selon la revendication 9 d'estimation de consommation d'un chauffe-eau électrique à accumulation mis en oeuvre par le système décrit précédemment. Le procédé en question comprend :
- mesurer, par le capteur de température, la température au niveau du tuyau d'extraction d'eau chaude,
- mesurer, par le capteur de champ magnétique, une intensité du champ magnétique au niveau du câble d'alimentation électrique.
Le procédé comprend en outre les étapes suivantes mises en oeuvre par le circuit de traitement du système :
- détecter, en fonction des mesures du capteur de champ magnétique, une ou plusieurs périodes de chauffe du chauffe-eau, puis estimer, en fonction de la ou des périodes de chauffe détectées et de caractéristiques électriques du chauffe-eau, une consommation électrique du chauffe-eau sur la période de temps, et
- détecter, en fonction des mesures du capteur de température, un ou plusieurs soutirages d'eau chaude du chauffe-eau, puis estimer, en fonction du ou des soutirages d'eau chaude détectés, une quantité d'eau chaude soutirée sur une période de temps donnée.

La mise en oeuvre de ce procédé permet à l'utilisateur du chauffe-eau électrique d'accéder à un bilan énergétique de son domicile, à savoir les consommations en énergie électrique et en eau du chauffe-eau électrique. Concernant la consommation en eau, l'utilisateur peut prendre connaissance de différentes informations telles que la quantité d'eau chaude soutirée ou la quantité d'eau chaude restante dans la cuve. La connaissance du bilan énergétique du chauffe-eau électrique permet à l'utilisateur de réaliser des économies d'énergie.

Dans un ou plusieurs modes de réalisation, le procédé comprend en outre : estimer, en fonction de la consommation électrique, de caractéristiques thermiques, du volume et d'une consigne de température du chauffe-eau, une quantité d'eau chaude produite sur la période de temps.

En particulier, la connaissance de l'eau chaude produite et de l'eau chaude soutirée permet à l'utilisateur de savoir quelle est la quantité d'eau chaude restante stockée dans la cuve.

Les caractéristiques électriques du chauffe-eau comprennent par exemple au moins une puissance électrique nominale du chauffe-eau.

Avantageusement, lorsque le système comprend un témoin visuel représentatif de l'intensité du champ magnétique mesurée par le capteur de champ magnétique, le procédé comprend en outre une étape préalable de positionnement, à l'aide du témoin visuel, du capteur de champ magnétique à proximité d'une position correspondant à une intensité du champ magnétique supérieure à une intensité minimale ou inférieure à une intensité maximale.

Par ailleurs, lorsque le circuit de traitement est localisé au niveau d'un serveur distant et que le système comprend en outre un module de communication, le procédé peut comprendre en outre : transmettre, via le module de communication, les mesures collectées par les capteurs au circuit de traitement.

Avantageusement, dans un ou plusieurs modes de réalisation dans lequel ou lesquels le système comprend en outre un module de pilotage du chauffe-eau, le procédé comprend en outre :
- bloquer toute chauffe du chauffe-eau lorsque la consommation électrique du chauffe-eau est supérieure à un seuil de consommation électrique prédéterminé sur la période de temps, ou
- autoriser une chauffe du chauffe-eau lorsqu'une quantité d'eau chaude restante, estimée en fonction de la quantité d'eau chaude soutirée estimée, est inférieure à un seuil de quantité d'eau chaude prédéterminé.

Enfin, la présente invention vise aussi un programme informatique comme défini dans la revendication 15, comprenant des instructions pour la mise en oeuvre des étapes du procédé destinées à être mises en oeuvre par le circuit de traitement, lorsque ces instructions sont exécutées par le circuit de traitement. Un tel programme informatique concerne donc les étapes du procédé spécifiquement mises en oeuvre par le circuit de traitement.

### Brève description des dessins

D'autres caractéristiques, détails et avantages apparaîtront à la lecture de la description détaillée ci-après, et à l'analyse des dessins annexés, sur lesquels :
**[****Fig. 1****]** illustre un système d'estimation de consommation d'un chauffe-eau électrique à accumulation selon l'invention ;
**[****Fig. 2A****]** illustre des moyens d'attache, à un câble d'alimentation d'électrique, d'un boîtier du système illustré en **[****Fig. 1****]** selon un premier mode de réalisation ;
**[****Fig. 2B****]** illustre des moyens d'attache, à un câble d'alimentation d'électrique, du boîtier du système illustré en **[****Fig. 1****]** selon un deuxième mode de réalisation ;
**[****Fig. 3A****]** illustre des moyens d'attache, à un câble d'alimentation d'électrique, du boîtier du système illustré en **[****Fig. 1****]** selon un troisième mode de réalisation ;
**[****Fig. 3B****]** illustre des moyens d'attache, à un câble d'alimentation d'électrique, du boîtier du système illustré en **[****Fig. 1****]** selon un quatrième mode de réalisation ; et
**[****Fig. 4****]** illustre un procédé d'estimation de consommation d'un chauffe-eau électrique à accumulation selon l'invention.

### Description des modes de réalisation

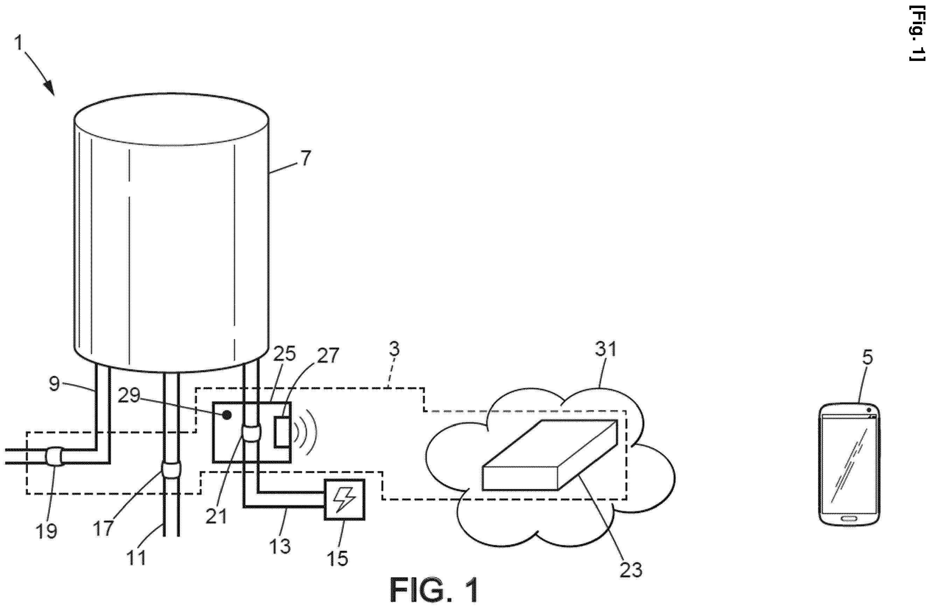

La **[****Fig. 1****]** illustre un chauffe-eau électrique à accumulation 1, ci-après chauffe-eau 1, un système 3 d'estimation de consommation d'un chauffe-eau électrique à accumulation tel que le chauffe-eau 1 et un terminal mobile 5.

Le chauffe-eau 1 est, de manière connue, un équipement domestique de production d'eau chaude sanitaire à l'aide d'une source d'énergie électrique. Dans le cas présent, le chauffe-eau 1 est un chauffe-eau électrique *à accumulation,* aussi appelé ballon d'eau chaude. Le chauffe-eau 1 fonctionne donc sur le principe de la production et du stockage d'eau chaude. L'eau chaude est ainsi produite seulement à certains moments de la journée et non sur demande. Le chauffe-eau 1 est par exemple piloté par le gestionnaire d'un réseau de distribution électrique.

Un tel fonctionnement permet de réduire la charge des réseaux de distribution électrique durant les périodes dites d'« heure pleine », lorsque la demande est forte, typiquement en journée. La production d'eau chaude sanitaire du chauffe-eau 1 est décalée dans le temps et repoussée à une période dite d'« heure creuse », typiquement la nuit. L'inertie thermique de l'eau chaude du chauffe-eau 1 permet un stockage sur une période suffisamment longue pour satisfaire les demandes en eau chaude sanitaire de l'utilisateur.

Une marche forcée peut toutefois être activée par l'utilisateur pour la production d'eau chaude en dehors des périodes de chauffe prévues.

Comme illustré en **[****Fig. 1****],** le chauffe-eau 1 comprend une cuve de stockage 7, un tuyau d'alimentation en eau froide 9, un tuyau d'alimentation en eau chaude 11 et un câble d'alimentation électrique 13.

La cuve de stockage 7, ci-après cuve 7, est agencée pour stocker de l'eau chaude. La cuve 7 présente un volume permettant plusieurs soutirages en eau chaude sanitaire de l'utilisateur au cours de la journée. Typiquement, dans un chauffe-eau domestique, la cuve 7 est dimensionnée en fonction du nombre d'utilisateurs potentiels et du nombre d'équipements sanitaires susceptibles de soutirer de l'eau chaude, tels qu'une douche ou une baignoire. La cuve 7 peut également être qualifiée de réservoir.

La cuve 7 est réalisée par exemple dans un matériau métallique et est protégée par un revêtement tel que de l'émail. De manière à protéger la cuve 7 de la corrosion, celle-ci peut comprendre une anode sacrificielle, typiquement en magnésium ou en titane. Une anode en magnésium présente l'avantage de protéger efficacement les parois internes de la cuve 7 et de renforcer l'émail par l'ajout d'une épaisseur supplémentaire. Toutefois, une anode en magnésium présente une durée de vie limitée. L'anode en titane présente une plus grande résistance et une meilleure longévité mais son efficacité dépend des minéraux présents dans l'eau, notamment le calcium et le magnésium.

Avantageusement, l'anode peut être hybride et combiner ainsi à la fois le magnésium et le titane. Une telle anode hybride présente l'efficacité d'une anode en magnésium et la longévité d'une anode en titane.

Par ailleurs, un système de chauffage, comprenant par exemple une résistance chauffante, peut être également agencé sur la cuve 7 ou à l'intérieur de celle-ci. La résistance chauffante peut ainsi être plongée dans la cuve 7 ou être placée à l'extérieur sans contact direct avec l'eau stockée. La résistance est bien souvent combinée à un thermostat de manière à contrôler la température de l'eau dans la cuve 7. La température de l'eau chaude doit typiquement être comprise entre 55°C et 60°C de manière à éviter à la fois la prolifération des bactéries dans la cuve 7 et un entartrage trop important.

Le tuyau d'alimentation en eau froide, ci-après tuyau d'alimentation 9, est agencé pour alimenter en eau froide le chauffe-eau 1. Plus spécifiquement, l'eau froide circulant dans le tuyau d'alimentation 9 est destinée à remplir la cuve 7.

Dans un fonctionnement classique, le tuyau d'alimentation 9 alimente en eau froide la cuve 7 lorsque de l'eau chaude est soutirée du chauffe-eau 1. L'eau froide injectée dans la cuve 7 est à son tour chauffée dans la cuve 7 par la résistance chauffante. Comme expliqué précédemment, l'eau froide est en fait chauffée dans une période d'heure creuse, généralement la nuit donc.

Toutefois, il est également possible pour l'utilisateur de forcer, manuellement par exemple, le chauffage de l'eau dans la cuve 7 en dehors de la période d'heure creuse de manière à disposer plus rapidement d'eau chaude.

Traditionnellement, l'arrivée d'eau froide se situe dans la partie inférieure de la cuve 7. Dans un tel cas, la résistance chauffante se trouve, elle aussi, au niveau de la partie inférieure de la cuve.

Le tuyau d'extraction d'eau chaude 11, ci-après tuyau d'extraction 11, est agencé pour soutirer l'eau chaude de la cuve 7 et ainsi alimenter, sur demande, un ou plusieurs équipements domestiques. Comme expliqué précédemment, l'eau chaude soutirée par le tuyau d'extraction 11 est remplacée par de l'eau froide injectée par le tuyau d'alimentation 9 puis chauffée, dans la cuve 7, par une résistance chauffante. La quantité d'eau stockée dans la cuve 7 est ainsi sensiblement constante au cours du temps.

L'extrémité du tuyau d'extraction 11 dans la cuve 7 se trouve habituellement dans la partie supérieure de celle-ci. En effet, du fait de la différence de densité, l'eau froide se trouve dans la partie inférieure de la cuve 7 tandis que l'eau chaude se trouve dans la partie supérieure.

Enfin, le câble d'alimentation électrique 13, ci-après câble 13, est agencé pour alimenter le chauffe-eau 1 en énergie électrique. Dans l'exemple illustré en **[****Fig. 1****],** le chauffe-eau 1 est alimenté, via le câble 13, par une source d'énergie électrique 15.

Par exemple, lors d'une période de chauffe de l'eau stockée dans la cuve 7, la source d'énergie électrique 15 alimente en énergie électrique le système de chauffage de la cuve 7 de sorte que la résistance chauffante, plongée dans la cuve 7 ou placée à l'extérieur de celle-ci, est mise sous tension et chauffe l'eau jusqu'à ce que celle-ci atteigne une température cible. A ce titre, le système de chauffage est configuré pour fonctionner selon une consigne de température.

Le chauffe-eau 1 décrit précédemment est bien connu de la personne du métier et seuls les éléments nécessaires à la compréhension et à la description de la présente invention ont été référencés sur la **[****Fig. 1****].** Bien entendu, la personne du métier comprend que le chauffe-eau 1 peut intégrer d'autres composants ou que les éléments décrits peuvent être agencés différemment.

Le système 3 est agencé pour l'estimation de la consommation d'un chauffe-eau électrique à accumulation tel que le chauffe-eau 1 décrit précédemment.

Plus précisément, dans le cadre de l'invention, le système 3 est agencé pour fournir à l'utilisateur, par exemple, un bilan des consommations en énergie électrique et en eau du chauffe-eau 1. La consommation électrique est liée essentiellement aux périodes de chauffe du chauffe-eau 1 au cours desquelles la source d'énergie électrique 15 alimente, via le câble 13, le système de chauffage, et notamment la résistance chauffante, de la cuve 7. La consommation en eau vise aussi bien la quantité d'eau chaude soutirée au chauffe-eau 1 que la quantité d'eau chaude produite par le chauffe-eau 1.

Le bilan énergétique généré par le système 3 permet à l'utilisateur de réaliser des économies, à la fois en énergie électrique et en eau chaude sanitaire.

Comme illustré en **[****Fig. 1****],** le système 3 comprend un capteur de température 17, un capteur de température 19 supplémentaire, un capteur de champ magnétique 21 et un circuit de traitement 23.

Le capteur de température 17 est agencé pour mesurer la température au niveau du tuyau d'extraction d'eau chaude 11 de la cuve 7 du chauffe-eau 1.

Le capteur de température 17 comprend typiquement des moyens d'attache pour être fixé de manière détachable sur le tuyau d'extraction 11. Ces moyens d'attache permettent de maintenir le capteur de température 17 à une position donnée au contact du tuyau d'extraction 11.

Le capteur de température 17 est par exemple configuré pour collecter des mesures de température à intervalles réguliers.

Lorsque l'utilisateur souhaite, au cours de la journée, soutirer de l'eau chaude sanitaire, une partie de l'eau chaude stockée dans la cuve 7 est conduite, par le tuyau d'extraction 11, depuis la cuve 7 vers l'équipement domestique en cours d'utilisation. Le capteur de température 17, agencé sur le tuyau d'extraction 11, est alors apte à mesurer une variation de température provoquée par la circulation de l'eau chaude.

Dans un exemple de réalisation, le capteur de température 17 est configuré pour collecter des mesures de température sur détection du dépassement d'un seuil de température prédéterminé. Un tel seuil permet d'éviter la collecte de données sans pertinence pour privilégier les mesures représentatives d'un soutirage d'eau chaude.

Le capteur de température 17 peut comprendre une mémoire configurée pour stocker les mesures de température réalisées, par exemple sur une période de temps donnée.

Le capteur de température 17 peut également comprendre des moyens de communication pour transmettre les mesures de température collectées. Ces moyens de communication peuvent être filaires ou non.

Avantageusement, comme illustré en **[****Fig. 1****],** le système 3 comprend, en plus du capteur de température 17 agencé sur le tuyau d'extraction 11, le capteur de température 19 supplémentaire.

Le capteur de température 19 est agencé pour mesurer la température au niveau du tuyau d'alimentation 9 d'alimentation en eau froide de la cuve 7 du chauffe-eau 1.

De même, que le capteur de température 17, le capteur de température 19 comprend typiquement des moyens d'attache pour être fixé de manière détachable sur le tuyau d'alimentation 9. Ces moyens d'attache permettent de maintenir le capteur de température 19 à une position donnée au contact du tuyau d'alimentation 9.

Le capteur de température 19 est par exemple configuré pour collecter des mesures de température à intervalles réguliers. Les intervalles de mesures du capteur de température 19 peuvent coïncider avec ou être distincts des intervalles de mesure du capteur de température 17.

Comme expliqué précédemment, le chauffe-eau 1 fonctionne de sorte que, lorsque l'utilisateur souhaite, au cours de la journée, utiliser de l'eau chaude sanitaire, l'eau chaude soutirée est alors remplacée, dans la cuve 7, par de l'eau froide injectée par le tuyau d'alimentation 9. Le capteur de température 19, agencé sur le tuyau d'alimentation 9, est alors apte à mesurer une variation de température provoquée par la circulation de l'eau froide.

Dans un exemple de réalisation, le capteur de température 19 est configuré pour collecter des mesures de température sur détection du dépassement d'un seuil de température prédéterminé. Un tel seuil permet d'éviter la collecte de données sans pertinence pour privilégier les mesures représentatives d'une injection d'eau froide. Ce seuil de température prédéterminé est bien entendu inférieur au seuil de température prédéterminé déclenchant la collecte de mesures du capteur de température 17, ce dernier étant en fait agencé sur le tuyau 11 d'extraction d'eau chaude de la cuve 7.

Le capteur de température 19 peut comprendre une mémoire configurée pour stocker les mesures de température réalisées, par exemple sur une période de temps donnée.

De même que le capteur de température 17, le capteur de température 19 peut comprendre des moyens de communication pour transmettre les mesures de température collectées. Ces moyens de communication peuvent être filaires ou non.

Le capteur de champ magnétique 21 est agencé pour mesurer une intensité du champ magnétique au niveau du câble 13 d'alimentation électrique du chauffe-eau 1.

Le capteur de champ magnétique 21 est par exemple configuré pour collecter des mesures de champ magnétique à intervalles réguliers. Les intervalles de mesures du capteur de champ magnétique 21 peuvent coïncider avec ou être distincts des intervalles de mesure du capteur de température 17 ou du capteur de température 19.

Comme expliqué précédemment, le chauffe-eau 1 produit de l'eau chaude seulement à certains moments de la journée, même s'il peut être prévu pour l'utilisateur la possibilité de faire fonctionner, en marche forcée, le chauffe-eau 1. Les périodes de chauffe du chauffe-eau 1 correspondent habituellement aux périodes d'heure creuse, donc pendant la nuit.

Lorsque l'eau chaude sanitaire est soutirée par l'utilisateur, via le tuyau d'extraction 11, de l'eau froide est injectée dans la cuve 7 du chauffe-eau 1 via le tuyau d'alimentation 9. L'eau froide injectée dans la cuve 7 est destinée à être chauffée lors de la prochaine période de chauffe programmée, et n'est donc pas forcément chauffée immédiatement. Lors d'une période de chauffe, la source d'énergie électrique 15 alimente, via le câble 13, le chauffe-eau 1, et plus exactement le système de chauffage, en énergie électrique.

Lorsque le système de chauffage en question comprend une résistance chauffante telle que décrite précédemment, la résistance chauffante est mise sous tension, par exemple jusqu'à ce que le thermostat monté sur la cuve 7 détecte l'atteinte ou le dépassement de la température visée, aussi appelée consigne de température.

Lors d'une période de chauffe, donc, le chauffe-eau 1 est alimenté en énergie électrique et la circulation du courant électrique dans le câble 13 génère un champ magnétique. Par exemple, si le câble 13 est un fil rectiligne, le courant électrique circulant dans le câble 13 génère un vecteur du champ magnétique dont le vecteur est contenu dans un plan orthogonal au câble 13. Dans le cas présent, le câble 13 comporte typiquement plusieurs conducteurs ou fils électriques, par exemple trois conducteurs monophasés ou cinq conducteurs triphasés. Le champ magnétique généré est alors la résultante des champs magnétiques respectivement générés par le courant électrique circulant dans chaque conducteur ou fil électrique.

Le capteur de champ magnétique 21 est par exemple une bobine ou un capteur à effet Hall.

Dans un exemple de réalisation, le capteur de champ magnétique 21 est configuré pour collecter des mesures d'intensité de champ magnétique sur détection du dépassement d'un seuil d'intensité de champ magnétique prédéterminé. Un tel seuil permet d'éviter la collecte de données sans pertinence pour privilégier les mesures représentatives d'une période de chauffe de l'eau stockée dans la cuve 7.

Comme illustré en **[****Fig. 1****],** le capteur de champ magnétique 21 est logé dans un boîtier 25.

Avantageusement, le boîtier 25 comprend un module de communication 27 et un témoin visuel 29.

Le module de communication 27 est configuré pour transmettre les mesures réalisées par les capteurs au circuit de traitement 23. Plus exactement, le module de communication 27 est configuré pour transmettre les mesures réalisées par le capteur de température 17, le capteur de champ magnétique 21 et, éventuellement, le capteur de température 19.

En effet, comme expliqué précédemment, le capteur de température 17 et le capteur de température 19 comprennent des moyens de communication pour transmettre les mesures de température collectées. Ainsi, ces moyens de communication peuvent être configurés pour transmettre les mesures de température collectées au boîtier 25.

Le boîtier 25 comprend par exemple une mémoire configurée pour stocker les mesures collectées par le capteur de température 17 et le capteur de température 19 et transmises au boîtier 25. La mémoire du boîtier 25 peut être configurée en outre pour stocker les mesures d'intensité de champ magnétique collectées par le capteur de champ magnétique 21. Les mesures ainsi stockées au sein du boîtier 25 sont ainsi prêtes à l'envoi, par le module de communication 27, à destination du circuit de traitement 23.

Typiquement, le module de communication 27 est configuré pour transmettre les mesures collectées et stockées à intervalles de temps réguliers de sorte que les mesures reçues par le circuit de traitement 23 sont relatives à une période de temps donnée, à savoir la période de temps au cours de laquelle les mesures auront été collectées par le capteur de température 17, le capteur de champ magnétique 21 et éventuellement le capteur de température 19 supplémentaire.

Dans un tel cas, la mémoire logée dans le boîtier 25 est par exemple une mémoire volatile configurée pour effacer les mesures stockées après transmission, par le module de communication 27 à destination du circuit de traitement 23, de ces mesures. En d'autres termes, les mesures déjà transmises par le module de communication 27 sont effacées et la mémoire est alors apte à stocker des nouvelles mesures correspondant à une nouvelle période de temps.

Le témoin visuel 29 est représentatif de l'intensité du champ magnétique mesurée par le capteur de champ magnétique 21.

Le témoin visuel 29 est par exemple positionné sur une surface extérieure du boîtier 25. Par ailleurs, le témoin visuel 29 informe visuellement sur demande en temps réel l'utilisateur de l'intensité du champ magnétique mesuré par le capteur de champ magnétique 21.

Par exemple, le témoin visuel 29 est configuré pour émettre une lumière dont l'intensité lumineuse, la longueur d'onde ou la fréquence de clignotement dépend de l'intensité du champ magnétique mesuré. Par exemple, l'intensité lumineuse, la longueur d'onde ou la fréquence de clignotement de la lumière émise par le témoin visuel 29 peut prendre une pluralité de valeurs discrètes de sorte que chacune de ces valeurs est associée à une gamme de valeurs d'intensité de champ magnétique. Des intensités ou des fréquences de clignotement spécifiques permettent d'indiquer un champ magnétique en dehors de la plage de fonctionnement nominal de la mesure, à savoir un champ magnétique trop faible ou trop élevé.

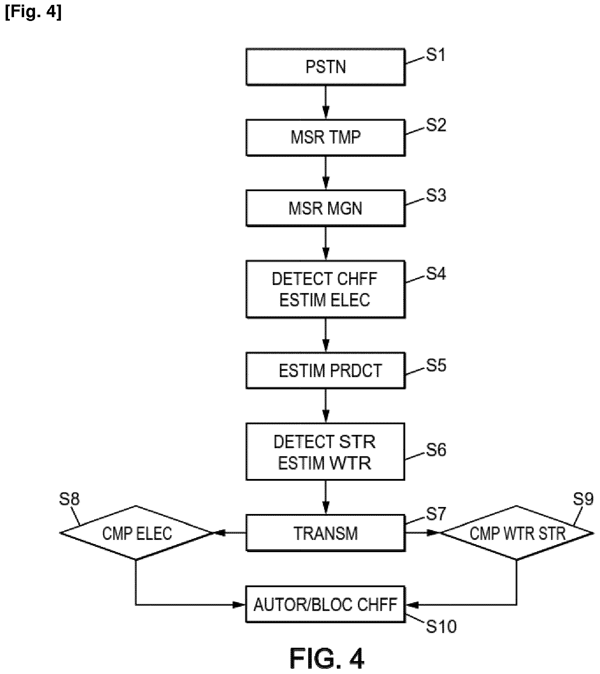

Comme expliqué dans la suite de la description en référence à la **[****Fig. 4****],** le témoin visuel 29 peut notamment être utilisé pour positionner le boîtier 25 de manière à mieux capter le champ magnétique généré par le courant électrique dans le câble 13.

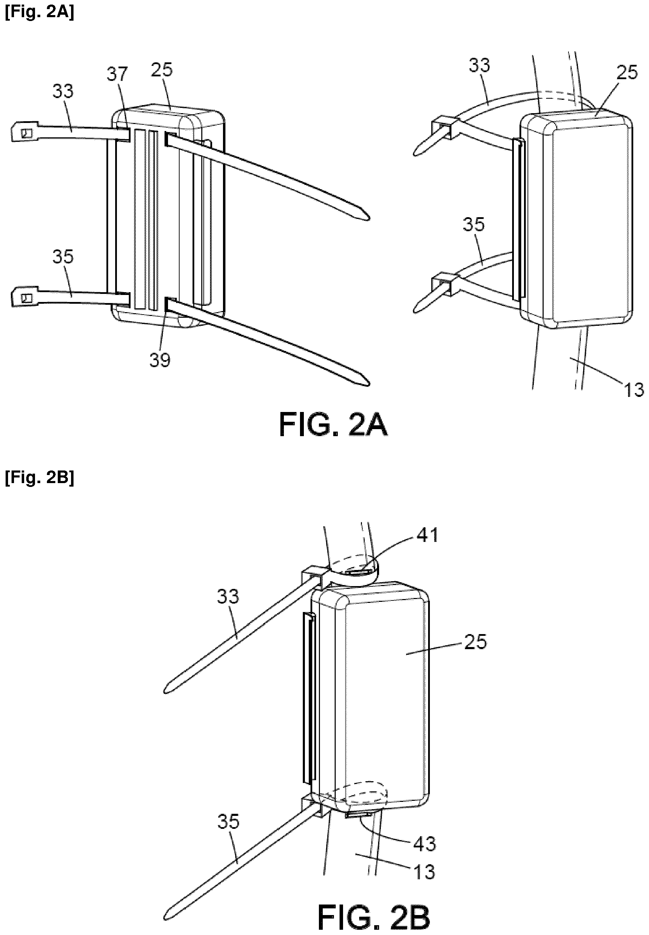

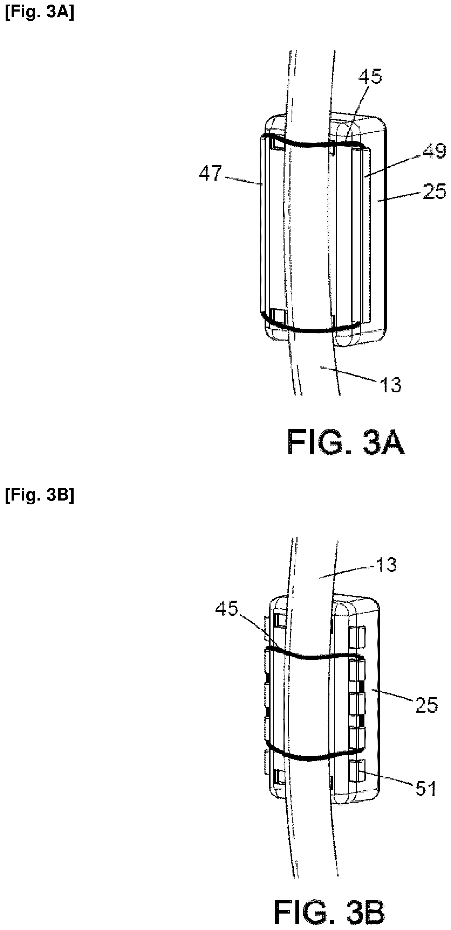

Par ailleurs, de même que le capteur de température 17 et le capteur de température 19, le boîtier 25 comprend avantageusement des moyens d'attache pour être fixé au câble 13. Différents moyens d'attache sont décrits ci-après en référence à la **[****Fig. 2A****],** à la **[Fig. 2B]** ,à la **[****Fig. 3A****]** et à la **[****Fig. 3B****].**

Dans la description des moyens d'attache du boîtier 25, il est à noter que ce dernier présente typiquement une face arrière, destinée à être en contact avec le câble 13 après fixation, et une face avant opposée à la face arrière. Le boîtier 25 comprend également au moins deux faces latérales s'étendant, après fixation du boîtier 25, dans le sens de la longueur du câble 13.

La **[****Fig. 2A****]** et la **[Fig. 2B]** illustrent des modes de réalisation dans lequel les moyens d'attache comprennent au moins un collier de serrage autobloquant. Plus spécifiquement, et comme illustré sur ces figures, les moyens d'attache comprennent un premier collier de serrage autobloquant 33 et un deuxième collier de serrage autobloquant 35.

Typiquement, un collier de serrage autobloquant comprend un ruban en matière plastique apte à être bouclé sur lui-même sur sa longueur. Le ruban présente généralement, sur l'une de ses faces, une succession de dents. Une extrémité du ruban présente une cage à cliquet anti-retour tandis que l'autre extrémité du ruban est affinée de manière à pouvoir être insérée dans la cage à cliquet anti-retour. Il est alors possible de boucler le collier de serrage autobloquant par insertion de l'extrémité affinée du ruban dans la cage à cliquet anti-retour de l'autre extrémité, les dents présentes sur une des faces du ruban empêchant un mouvement en sens inverse.

Dans le mode de réalisation illustré en **[****Fig. 2A****],** le boîtier 25 présente, sur une de ses faces, ici la face arrière, un trou traversant conformé et dimensionné pour autoriser le passage du collier de serrage autobloquant. Plus précisément, le boîtier 25 présente un premier trou traversant 37 conformé et dimensionné pour autoriser le passage du premier collier de serrage autobloquant 33 et un deuxième trou traversant 39 conformé et dimensionné pour autoriser le passage du deuxième collier de serrage 35. Dans l'exemple décrit ici, les ouvertures de chaque trou traversant 37, 39 - un trou traversant 37, 39 en comprend deux - sont ménagés sur une même face du boîtier 25. Chaque collier de serrage autobloquant 33, 35 est ainsi inséré dans le boîtier 25 dans une ouverture d'un trou traversant 37, 39 sur la face arrière du boîtier 25 et en ressort par une autre ouverture ménagée sur cette même face arrière.

Toujours en référence à la **[****Fig. 2A****],** le boîtier 25 est adapté pour être fixé au câble 13 d'alimentation électrique par bouclage du collier de serrage 33, 35 autour du câble 13 en passant par le trou traversant 37, 39 associé. En d'autres termes, la face arrière du boîtier 25 sur laquelle est ménagé chaque trou traversant 37, 39 est la face destinée être en contact avec le câble 13 après fixation du boîtier 25.

Dans le mode de réalisation illustré en **[Fig. 2B]** ,le boîtier 25 présente cette fois-ci au moins une portion faisant saillie du boîtier 25. Plus précisément, dans l'exemple développé ici, le boîtier 25 présente une première portion 41 en saillie associée au premier collier de serrage autobloquant 33 et une deuxième portion 43 en saillie associée au deuxième collier de serrage autobloquant 35.

Chaque portion 41, 43 en saillie prend ici la forme d'une languette dans le prolongement d'une des faces du boîtier 25, en l'occurrence la face arrière destinée à être en contact avec le câble 13 après fixation du boîtier 25. La portion 41, 43 en saillie présente alors une forme mince, étroite et allongée.

Le boîtier 25 est ainsi adapté pour être fixé au câble 13 d'alimentation électrique par bouclage du collier de serrage autobloquant 33, 35 à la fois autour du câble 13 et de la portion 41, 43 en saillie correspondante.

Chaque collier de serrage 33, 35 permet ainsi de maintenir la portion 41, 43 en saillie en contact avec le câble 13 et, par conséquent, de maintenir le boîtier 25 contre le câble 13. Comme illustré sur la **[Fig. 2B]** ,chaque portion 41, 43 est une languette dont la forme allongée s'étend dans le sens de la longueur du câble 13 après fixation.

Avantageusement, l'extrémité de chaque portion 41, 43 en saillie est courbée de manière à former une butée. Une telle butée permet d'empêcher le collier de serrage autobloquant 33, 35 de se déplacer le long du câble 13 au-delà de la languette ce qui entrainerait un détachement du boîtier 25 qui ne serait alors plus au contact du câble 13.

Il convient de noter que les modes de réalisation illustrés respectivement sur la **[****Fig. 2A****]** et la **[Fig. 2B]** peuvent être combinés pour attacher plus efficacement encore le boîtier 25 au câble 13.

La **[****Fig. 3A****]** et la **[****Fig. 3B****]** illustrent des modes de réalisation dans lequel les moyens d'attache comprennent au moins un élastique. Plus spécifiquement, et comme illustré sur ces figures, les moyens d'attache comprennent un seul élastique 45.

Le boîtier 25 présente une ou plusieurs paires de crochets agencés sur des faces opposées du boîtier 25. Dans le cas discuté ici, les crochets sont agencés sur des faces latérales opposées du boîtier 25. Ces faces latérales s'étendent, après fixation du boîtier 25 au câble 13, dans le sens de la longueur du câble 13.

Plus spécifiquement, dans le mode de réalisation illustré en **[****Fig. 3B****],** le boîtier 25 présente une seule paire de crochets 47, 49. Dans ce cas particulier, chaque crochet 47, 49 s'étend respectivement sur la longueur d'une face latérale du boîtier 25 et prend la forme d'un rail apte à recevoir une portion au moins de l'élastique 45.

Dans cet exemple, le boîtier 25 est adapté pour être fixé au câble 13 d'alimentation électrique par rappel de l'élastique 45 accroché au boîtier 25 via la paire de crochets 47, 49 en forme de rail. Le boîtier 25 et l'élastique 45 enserrent ainsi ensemble le câble 13 pris entre les deux.

En d'autres termes et comme illustré sur la **[****Fig. 3A****],** le câble 13 est encerclé par l'ensemble formé par le boîtier 25 et l'élastique 45. Une portion de l'élastique 45 est logée dans le rail 47 sur une face latérale du boîtier 25 tandis qu'une autre portion de l'élastique 45 est logée dans le rail 49 sur une autre face latérale du boîtier 25, opposée à la face latérale présentant le rail 47. L'élastique 45 exerce alors une force de rappel sur le boîtier 45, lequel est alors plaqué contre le câble 13. De même, la partie de l'élastique 45 à l'extérieur des logements formés par les rails 47, 49 est maintenue en appui contre le câble 13.

A l'inverse, dans le mode de réalisation illustré en **[****Fig. 3B****],** le boîtier 25 présente plusieurs paires de crochets 51. Chaque crochet 51 agencé sur une face latérale du boîtier 25 est en regard d'un crochet complémentaire agencé sur la face latérale opposée.

De même que dans le mode de réalisation de la **[****Fig. 3A****],** le boîtier 25 est adapté pour être fixé au câble 13 d'alimentation électrique par rappel de l'élastique 45 accroché au boîtier 25 via les paires de crochets 51. Le boîtier 25 et l'élastique 45 enserrent ainsi le câble 13. Le câble 13 est encerclé par l'ensemble formé par le boîtier 25 et l'élastique 45.

Il est à noter que les moyens d'attache du boîtier 25 décrits précédemment permettent de s'adapter à différentes sections du câble 13. Autrement dit, ces moyens d'attache permettent de positionner le boîtier 25 à des emplacements différents du câble 13 quand bien même l'épaisseur du câble 13 serait variable d'une extrémité à une autre.

En particulier, l'utilisation du collier de serrage autobloquant 33, 35 permet, à l'aide de la succession de dents présente sur une face du collier de serrage autobloquant 33, 35, de s'adapter à la section du câble 13. Il en est de même pour l'élastique 45 qui, du fait de sa souplesse et de son élasticité caractéristique, peut s'adapter à l'épaisseur du câble 13. Il est en particulier avantageux de sélectionner, pour l'emplacement du boîtier 25, une portion du câble 13 présentant une section d'épaisseur suffisante pour que l'élastique 45, après fixation du boîtier 25, exerce une force de rappel suffisamment importante pour maintenir en place le boîtier 25. Par ailleurs, dans le mode de réalisation illustré en **[****Fig. 3B****],** les multiples paires de crochets 51 offrent une plus grande liberté dans le positionnement de l'élastique 45, lequel pouvant n'être accroché au boîtier 25 que par une partie des crochets 51. Il est alors possible, pour modifier la force de rappel exercée par l'élastique 45, de choisir non seulement un tronçon adapté du câble 13 mais aussi les crochets 51 retenant l'élastique 45.

II est à noter que les moyens d'attache du capteur de température 17 et du capteur de température 19 supplémentaire peuvent être similaires aux moyens d'attache du capteur de champ magnétique 21 décrits précédemment. Chaque capteur peut ainsi être installé de manière non intrusive avec des moyens d'attache simples d'utilisation.

De nouveau en référence à la **[****Fig. 1****],** le circuit de traitement 23 est configuré pour estimer sur une période de temps donnée, en fonction des mesures du capteur de température 17 et du capteur de champ magnétique 21, des consommations en énergie électrique et en eau du chauffe-eau 1.

Avantageusement, le circuit de traitement 23 est configuré pour estimer les consommations en énergie électrique et en eau du chauffe-eau 1 en fonction en outre des mesures d'un capteur de température supplémentaire, à savoir ici le capteur de température 19 agencé pour mesurer la température au niveau du tuyau 9 d'alimentation en eau froide de la cuve 7 de stockage du chauffe-eau 1.

Dans l'exemple illustré en **[****Fig. 1****],** le circuit de traitement est localisé au niveau d'un serveur distant accessible via un réseau 31.

Dans un tel mode de réalisation, le module de communication 27 du système 3, par exemple logé dans le boîtier 25, est configuré pour transmettre les mesures collectées par les capteurs au circuit 23 via le réseau 31.

Il est connu de la personne du métier, qu'il existe de nombreux types différents de réseaux de communication de données, par exemple des réseaux de radiocommunication, cellulaires ou non cellulaires, et qu'en fonction du mode de réalisation, le module de communication 27 pourra intégrer un ou plusieurs sousmodules de communication, par exemple de communication radiofréquence et être configuré pour l'émission et la réception de signaux radiofréquences, selon une ou plusieurs technologies, telles que TDMA, FDMA, OFDMA, CDMA, ou un ou plusieurs standards de radiocommunication, tels que GSM, EDGE, CDMA, UMTS, HSPA, LTE, LTE-A, WiFi (IEEE 802.11) et WiMAX (IEEE 802.16), ou leurs variantes ou évolutions, actuellement connus ou développés ultérieurement.

Comme expliqué précédemment, le module de communication 27 est typiquement configuré pour transmettre les mesures collectées à intervalles de temps réguliers. Dans un tel mode de réalisation, les mesures collectées par les capteurs sont stockées dans une mémoire, accessible au module de communication 27, et ce dernier émet les mesures stockées au cours d'une période de temps donnée à destination du circuit de traitement 23. Une fois les mesures reçues, le circuit de traitement 23 est alors apte à estimer, pour cette période de temps donnée, les consommations en énergie électrique et en eau du chauffe-eau 1.

Enfin, le terminal mobile 5 est adapté pour informer un utilisateur, notamment l'utilisateur du chauffe-eau 1, des consommations en énergie électrique et en eau du chauffe-eau 1.

Le terminal mobile 5 comprend un module de communication configuré pour recevoir, en provenance du circuit de traitement 23, des informations et des données représentatives des estimations des consommations en énergie électrique et en eau du chauffe-eau 1. Ces informations et données sont par exemple transmises au terminal mobile 5 via le réseau 31.

Ces estimations peuvent être accessibles à l'utilisateur du terminal mobile 5 via une application native ou web exécutée sur le terminal mobile 5. Il est alors possible pour l'utilisateur du terminal mobile 5 d'exécuter cette application sur le terminal mobile 5 et d'accéder à un bilan énergétique du chauffe-eau 1 affiché sur un écran du terminal mobile 5. Le terminal mobile 5 peut être un « téléphone intelligent », plus connu sous le terme anglophone « smartphone ».

L'application en question peut nécessiter une inscription de l'utilisateur et le renseignement de données telles qu'un numéro de mobile, un mot de passe ou des données personnelles telles que son adresse de domicile. Après inscription, l'utilisateur peut alors exécuter l'application sur le terminal mobile 5 et accéder directement à un bilan énergétique lui permettant de connaître l'estimation des consommations en énergie électrique et en eau du chauffe-eau.

Une telle application peut offrir à l'utilisateur des fonctionnalités autres que l'affichage d'un bilan énergétique. Cette application peut alerter l'utilisateur lorsqu'une quantité d'eau chaude restante dans la cuve 7 du chauffe-eau 1 est inférieure à un seuil de quantité d'eau chaude prédéterminé. L'application peut également alerter l'utilisateur lorsque la consommation électrique du chauffe-eau 1 est supérieure à un seuil de consommation électrique.

Par ailleurs, comme expliqué précédemment, un chauffe-eau électrique à accumulation tel que le chauffe-eau 1 fonctionne habituellement au rythme des périodes d'heure creuse et d'heure pleine. La production d'eau chaude sanitaire du chauffe-eau 1 est ainsi mise en oeuvre lors des périodes d'heure creuse. Il est toutefois possible pour l'utilisateur d'actionner une marche forcée pour contraindre le chauffe-eau 1 à produire de l'eau chaude sanitaire en dehors des périodes d'heure creuse.

Lorsqu'une telle possibilité est ouverte à l'utilisateur, le terminal mobile 5 peut lui permettre, via l'application, d'activer à distance cette marche forcée en fonction du bilan énergétique reçu. A l'inverse, l'utilisateur peut aussi bloquer, si nécessaire, le fonctionnement du chauffe-eau 1 et empêcher, notamment pendant une période d'heure creuse, le chauffe-eau 1 de chauffer l'eau stockée dans la cuve 7.

Un procédé d'estimation de consommation d'un chauffe-eau électrique à accumulation mis en oeuvre par le système 3 décrit précédemment va à présent être décrit en référence à la **[****Fig. 4****].**

Dans le contexte de la mise en oeuvre du procédé, le système 3 d'estimation de consommation d'un chauffe-eau électrique à accumulation est installé sur le chauffe-eau 1 illustré en **[****Fig. 1****].** L'installation du système 3 permet à l'utilisateur du chauffe-eau 1 d'avoir accès à un bilan énergétique concernant les consommations en énergie électrique et en eau chaude sanitaire du chauffe-eau 1.

Le système 3 a l'avantage de pouvoir être installé sans connaissance approfondie en plomberie ou en électricité de sorte que l'intervention d'un professionnel n'est pas requise. Les capteurs du système 3 sont en effet des capteurs non intrusifs et peuvent donc être agencés directement sur le chauffe-eau 1. Ainsi, le capteur de température 17 peut être installé, à l'aide de moyens d'attache, sur le tuyau 11 d'extraction d'eau chaude de la cuve 7 du chauffe-eau 1. De même, le capteur de température 19 comprend lui aussi des moyens d'attache pour être installé sur le tuyau 9 d'alimentation en eau froide de la cuve 7.

Lors d'une étape S1, le capteur de champ magnétique 21 est installé sur le câble 13 d'alimentation électrique du chauffe-eau 1.

Dans l'exemple décrit ici, le capteur de champ magnétique 21 est logé dans un boîtier 25 comprenant, sur une surface extérieure, un témoin visuel 29 représentatif de l'intensité du champ magnétique mesurée par le capteur de champ magnétique 21.

Le boîtier 25 comprend par ailleurs des moyens d'attache tels que ceux décrit plus haut en référence à la **[****Fig. 2A****],** à la **[Fig. 2B]** ,à la **[****Fig. 3A****]** et à la **[****Fig. 3B****].** Les moyens d'attache permettent de s'adapter à la section du câble 13 ou à son épaisseur qui peut varier d'une extrémité à l'autre du câble 13. Ainsi, le boîtier 25 peut être installé à plusieurs positions différentes le long du câble 13.

Ainsi, au cours de cette étape S1, le capteur de champ magnétique 21, et plus exactement le boîtier 25, est positionné, à l'aide du témoin visuel 29, à proximité d'une position correspond à une intensité du champ magnétique supérieure à une intensité minimale et inférieure à une intensité maximale.

En effet, la circulation du courant électrique dans le câble 13 génère un champ magnétique. Ce champ magnétique n'est toutefois pas uniforme le long du câble 13 de sorte que l'intensité du champ magnétique mesurée par le capteur de champ magnétique 21 à une position donnée peut être différente de l'intensité du champ magnétique mesurée à une autre position.

Ainsi, en utilisant l'information visuelle fournie par le témoin visuel 29, il est possible de déterminer si, à une position donnée, l'intensité de champ magnétique mesurée par le capteur de champ magnétique 21 est suffisante ou non. Par exemple, le témoin visuel 29 est configuré pour passer d'un premier état à un second état et réciproquement. Dans le premier état, le témoin visuel 29 informe visuellement l'utilisateur que l'intensité de champ magnétique mesurée est supérieure à une intensité minimale de champ magnétique et inférieure à une intensité maximale. A l'inverse, dans le second état, le témoin visuel 29 informe visuellement l'utilisateur que l'intensité de champ magnétique mesurée est inférieure à l'intensité minimale de champ magnétique ou supérieure à l'intensité maximale. Le témoin visuel 29 peut émettre une lumière dont l'intensité lumineuse ou la longueur d'onde ou la fréquence de clignotement dépend de l'intensité du champ magnétique mesuré.

La flexibilité des moyens d'attache du boîtier 25, que ce soit avec un collier de serrage autobloquant 33, 35 ou avec l'élastique 45, permet de déplacer le boîtier 25 le long du câble 13 jusqu'à trouver une position satisfaisante avec une intensité du champ magnétique suffisamment élevée pour être détectée et mesurée par le capteur de champ magnétique 21.

Une fois le capteur de champ magnétique 21 installé sur le câble 13, le système 3 peut fonctionner tel que décrit ci-après, toujours en référence à la **[****Fig. 4****].**

Lors d'une étape S2, le capteur de température 17 mesure la température au niveau du tuyau 11 d'extraction d'eau chaude de la cuve 7.

Comme expliqué précédemment, le capteur de température 17 collecte par exemple les mesures de température à intervalles de temps réguliers et non en continu. Les mesures de température collectées peuvent ensuite être stockées dans une mémoire du capteur de température 17 ou être transmises directement, via des moyens de communication, au boîtier 25 pour être stockées dans la mémoire logée dans le boîtier 25.

Au cours de cette étape S2, dans le mode de réalisation dans lequel le système 3 comprend en outre le capteur de température 19, le capteur de température 19 mesure également la température au niveau du tuyau 9 d'alimentation en eau froide de la cuve 7.

De même que le capteur de température 17, le capteur de température 19 collecte par exemple les mesures de température à intervalles de temps réguliers et non en continu. Les mesures de température collectées peuvent ensuite être stockées dans une mémoire du capteur de température 19 ou être transmises directement, via des moyens de communication, au boîtier 25 pour être stockées dans la mémoire logée dans le boîtier 25.

Lors d'une étape S3, le capteur de champ magnétique 21 mesure une intensité du champ magnétique au niveau du câble 13 d'alimentation électrique du chauffe-eau 1.

De même que le capteur de température 17 et le capteur de température 19 supplémentaire, le capteur de champ magnétique 21 collecte par exemple les mesures d'intensité de champ magnétique à intervalles de temps réguliers et non en continu. Les mesures d'intensité de champ magnétique collectées peuvent ensuite être stockées dans la mémoire logée dans le boîtier 25.

Bien entendu, les étapes S2 et S3 peuvent se dérouler simultanément ou l'une après l'autre. A l'issue de ces étapes, le système 3 dispose de mesures, sur une période de temps donnée, de température et de champ magnétique. Ces mesures sont alors transmises au circuit de traitement 23.

En particulier, lorsque le circuit de traitement 23 est localisé au niveau d'un serveur distant, les mesures collectées et stockées sont transmises par le module de communication 27 à destination du circuit de traitement 23 via le réseau 31.

Lors d'une étape S4, le circuit de traitement détecte, en fonction des mesures du capteur de champ magnétique 21, une ou plusieurs périodes de chauffe du chauffe-eau 1.

En effet, lors d'une période de chauffe du chauffe-eau 1, la source d'énergie électrique 15 alimente en énergie électrique le système de chauffage de la cuve 7 via le câble 13. Ce système de chauffage comprend typiquement une résistance dont la mise sous tension permet de chauffer l'eau stockée dans la cuve 7, et notamment l'eau froide récemment injectée par le tuyau 9.

La présence d'un champ magnétique indique une circulation du courant électrique dans le câble 13 et donc une période de chauffe du chauffe-eau 1.

Toujours au cours de cette étape S4, le circuit de traitement 23 estime, en fonction de la ou des périodes de chauffe détectées et de caractéristiques électriques du chauffe-eau 1, une consommation électrique du chauffe-eau 1 sur la période de temps.

Le relevé des mesures d'intensité du champ magnétique fourni par le capteur de champ magnétique 21 permet en effet de connaître l'énergie électrique fournie, sur la période de temps donnée, au chauffe-eau 1. Ce relevé permet également de déterminer la durée de chaque période de chauffe. Le circuit de traitement 23 peut ensuite, avec ces informations combinées à la connaissance préalable des caractéristiques électriques du chauffe-eau 1, estimer la consommation électrique du chauffe-eau 1 sur la période de temps considérée.

Les caractéristiques électriques comprennent par exemple au moins une puissance électrique nominale du chauffe-eau 1.

Lors d'une étape S5, le circuit de traitement 23 estime, en fonction de la consommation électrique, mais aussi au moins de caractéristiques thermiques, du volume, de la consigne de température du chauffe-eau 1, une quantité d'eau chaude produite sur la période de temps considérée.

L'estimation de la consommation en eau peut en effet désigner non seulement la quantité d'eau chaude soutirée mais aussi la quantité d'eau chaude produite par le chauffe-eau 1.

Lors d'une étape S6, le circuit de traitement 23 détecte, en fonction des mesures du capteur de température 17, et éventuellement des mesures du capteur de température 19, un ou plusieurs soutirages d'eau chaude du chauffe-eau 1. En effet, un soutirage d'eau chaude sanitaire se traduit par la circulation dans le tuyau 11 d'eau chaude en provenance de la cuve 7 à destination d'un équipement sanitaire sollicité par l'utilisateur. La circulation d'eau chaude a un impact direct sur la température mesurée par le capteur de température 17 de sorte que le circuit de traitement 23 peut, à l'aide des températures relevées par le capteur de température 17, détecter le soutirage d'eau chaude.

Par ailleurs, le chauffe-eau 1 fonctionne de sorte que la quantité d'eau stockée dans la cuve 7 est sensiblement constante au cours du temps. Ainsi, en réponse à chaque soutirage d'eau chaude, de l'eau froide est injectée dans la cuve 7 via le tuyau 9. La circulation d'eau froide dans le tuyau 9 a un impact direct sur la température mesurée par le capteur de température 19 de sorte que le circuit de traitement 23 peut, à l'aide également des températures relevées par le capteur de température 19, détecter l'injection d'eau froide et donc le soutirage d'eau chaude.

Selon l'invention, les soutirages d'eau chaude détectés sont classifiés par le circuit de traitement 23 en fonction de l'évolution temporelle des températures mesurées, par le capteur de température 17 et, optionnellement, par le capteur de température 19, entre le début et la fin du soutirage.

Par ailleurs, toujours au cours de cette étape S6, le circuit de traitement 23 estime, en fonction du ou des soutirages d'eau chaude détectés et de la classe du ou des soutirages, une quantité d'eau chaude soutirée pour chaque soutirage sur une période de temps donnée.

En effet, le relevé de températures du capteur de température 17 permet d'estimer la durée du soutirage d'eau chaude, de sorte que le circuit de traitement 23 peut, en prenant en considération la classe du soutirage, déterminer la quantité totale d'eau chaude sanitaire soutirée sur la période de temps considérée.

L'estimation de la quantité d'eau chaude produite permet, avec l'estimation de la quantité d'eau chaude soutirée, de déterminer la quantité d'eau chaude dans la cuve 7 disponible pour l'utilisateur. En effet, la détection d'une période de chauffe et les informations relatives à cette période de chauffe, notamment sa durée ainsi que les caractéristiques électriques et thermiques du chauffe-eau 1, permettent d'estimer la quantité totale d'eau chaude disponible dans la cuve 7 à l'issue de cette période de chauffe. Par la suite, partant de la quantité d'eau chaude sanitaire initiale disponible, la détection des soutirages d'eau chaude au cours de période de temps suivant la période de chauffe permet, par soustraction des volumes d'eau chaude correspondant, d'estimer la quantité d'eau chaude encore disponible après les soutirages, donc la quantité d'eau chaude restante dans la cuve 7 du chauffe-eau 1.

Avantageusement, lors d'une étape S7, le circuit de traitement 23 transmet des données et des informations relatives aux consommations en énergie électrique et en eau du chauffe-eau 1 à destination du terminal mobile 5. Cette transmission est par exemple mise en oeuvre via le réseau 31.

Comme détaillé plus haut, ces données et informations peuvent être accessibles à l'utilisateur du terminal mobile 5 via une application exécutée sur le terminal mobile 5. Cette application affiche alors à l'utilisateur un bilan énergétique du chauffe-eau 1.

L'utilisateur a ainsi connaissance de la consommation en énergie électrique du chauffe-eau 1 sur une période de temps donnée. L'utilisateur peut également connaître l'estimation de la quantité d'eau chaude soutirée pour l'utilisation des équipements sanitaires alimentés en eau chaude par le chauffe-eau 1.

Comme détaillé précédemment, l'application peut permettre à l'utilisateur d'accéder à davantage d'informations relatives à la consommation en eau du chauffe-eau 1, comme par exemple la quantité d'eau chaude sanitaire produite ainsi que la quantité d'eau chaude restante dans la cuve 7 et donc disponible.

Lors d'une étape S8, par exemple mise en oeuvre par l'application sur demande de l'utilisateur du terminal mobile 5, la consommation en énergie électrique du chauffe-eau 1 sur une période donnée est comparée à un seuil de consommation électrique prédéterminé. L'utilisateur du terminal mobile 5 peut par exemple définir un tel seuil de consommation électrique et configurer l'application de manière à recevoir une alerte quand ce seuil de consommation électrique est atteint ou que la consommation électrique du chauffe-eau 1 s'approche de ce seuil.

De la même manière, lors d'une étape S9 qui peut aussi être mise en oeuvre par l'application sur demande de l'utilisateur, la consommation en eau chaude sanitaire sur une période donnée est comparée à un seuil de quantité d'eau chaude prédéterminé. Par exemple, cette consommation en eau chaude concerne la quantité d'eau chaude produite par le chauffe-eau 1. Toutefois, cette consommation en eau chaude peut concerner également la quantité d'eau chaude disponible. Ainsi, cette comparaison peut permettre d'informer l'utilisateur que la quantité d'eau chaude produite est inférieure à un seuil correspondant à la quantité d'eau chaude à produire. Cette comparaison peut également permettre d'alerter l'utilisateur quand l'eau chaude disponible est insuffisante. Dans ce dernier cas, le seuil correspond par exemple à la quantité d'eau chaude sanitaire journalière soutirée en moyenne par l'utilisateur.

Lors d'une étape S10, sur la base des comparaisons effectuées par l'application ou sur demande de l'utilisateur après avoir pris connaissance du bilan énergétique et des informations relatives à l'état du chauffe-eau 1, le fonctionnement de celui-ci peut être modifié à distance. Cette modification peut être justifiée par le souci de réaliser des économies d'énergie ou pour satisfaire aux besoins en eau chaude sanitaire de l'utilisateur.

Par exemple, il est possible de bloquer toute chauffe du chauffe-eau 1 lorsque la consommation électrique du chauffe-eau 1 est supérieure à un seuil de consommation électrique prédéterminé sur une période de temps. Ce blocage peut être automatique ou piloté par l'utilisateur.

Il est également possible d'autoriser une chauffe du chauffe-eau 1 lorsqu'une quantité d'eau chaude restante, estimée en fonction de la quantité d'eau chaude soutirée estimée, est inférieure au seuil de quantité d'eau chaude prédéterminé. En d'autres termes, si l'eau chaude disponible stockée dans la cuve 7 n'est pas suffisante pour satisfaire les besoins en eau chaude sanitaire de l'utilisateur, une période de chauffe peut être déclenchée, même en dehors des périodes de chauffe prévues, donc même en en dehors des périodes d'heure creuse, pour produire une quantité d'eau chaude supplémentaire.

La présente invention présente plusieurs avantages.

Tout d'abord, les capteurs du système sont non intrusifs et peuvent être installés sur le chauffe-eau électrique à accumulation sans l'intervention d'un professionnel disposant de connaissances approfondies en plomberie ou en électricité. En particulier, les capteurs de température, agencés respectivement sur le tuyau d'extraction d'eau chaude et sur le tuyau d'alimentation en eau froide, permettent de détecter avec précision les soutirages en eau chaude du chauffe-eau. De même, le capteur de champ magnétique agencé sur le câble d'alimentation électrique permet de détecter avec précision des périodes de chauffe du chauffe-eau.

Par ailleurs, les moyens d'attache du boîtier au sein duquel est logé le capteur de champ magnétique permettent, quel que soit d'ailleurs le mode de réalisation choisi, de s'adapter à la section ou à l'épaisseur du câble. D'autre part, la présence sur une surface extérieure du boîtier du témoin visuel permet de s'assurer une utilisation optimale du capteur de champ magnétique puisque celui-ci peut être placé sur le câble à une position correspondant à une intensité du champ magnétique satisfaisante.

Enfin, le traitement des mesures au niveau du circuit de traitement permet de fournir, par exemple via une application, un bilan énergétique du chauffe-eau à un utilisateur et donc de réaliser des économies d'énergie. Le circuit de traitement peut ainsi informer l'utilisateur lorsque la consommation en énergie électrique du chauffe-eau est trop élevée ou lorsque la quantité d'eau chaude disponible est trop faible. Ainsi, l'utilisateur peut modifier à distance le régime de fonctionnement du chauffe-eau de manière ciblée et plus efficace pour répondre à ses besoins.

## Revendications

1. Système (3) d'estimation de consommation d'un chauffe-eau (1) électrique à accumulation,
ledit système comprenant :
- un capteur de température (17) agencé pour mesurer la température au niveau d'un tuyau (11) d'extraction d'eau chaude d'une cuve (7) de stockage dudit chauffe-eau et apte à mesurer une variation de température provoquée par la circulation de l'eau chaude,
- un capteur de champ magnétique (21) agencé pour mesurer une intensité du champ magnétique au niveau d'un câble (13) d'alimentation électrique dudit chauffe-eau, et
- un circuit de traitement (23) configuré pour :
détecter, en fonction des mesures du capteur de champ magnétique, une ou plusieurs périodes de chauffe du chauffe-eau, puis estimer, en fonction de la ou des périodes de chauffe détectées et de caractéristiques électriques du chauffe-eau, une consommation électrique du chauffe-eau sur une période de temps donnée, et détecter, en fonction des mesures du capteur de température, un ou plusieurs soutirages d'eau chaude du chauffe-eau, classifier le ou les soutirages d'eau chaude, en fonction d'une évolution temporelle des températures mesurées par le capteur de température entre le début et la fin du soutirage, puis estimer, en fonction du ou des soutirages d'eau chaude détectés et de la classe du ou des soutirages, une quantité d'eau chaude soutirée sur ladite période de temps.

2. Système selon la revendication 1, comprenant en outre un capteur de température (19) supplémentaire agencé pour mesurer la température au niveau d'un tuyau (9) d'alimentation en eau froide de la cuve de stockage du chauffe-eau et apte à mesurer une variation de température provoquée par la circulation de l'eau froide,
le circuit de traitement étant configuré pour détecter un ou plusieurs soutirages d'eau chaude du chauffe-eau en fonction en outre des mesures du capteur de température supplémentaire.

3. Système selon la revendication 1 ou 2, dans lequel un ou plusieurs des capteurs sont configurés pour collecter des mesures à intervalles de temps réguliers.

4. Système selon l'une des revendications précédentes, comprenant en outre un module de communication (27) configuré pour transmettre les mesures réalisées par les capteurs au circuit de traitement, ledit circuit de traitement étant localisé au niveau d'un serveur distant.

5. Système selon l'une des revendications précédentes, dans lequel le capteur de champ magnétique est logé dans un boîtier (25) comprenant des moyens d'attache pour être fixé au câble d'alimentation électrique.

6. Système selon la revendication 5, dans lequel les moyens d'attache comprennent un collier de serrage (33, 35) autobloquant et dans lequel le boîtier présente :
- un trou traversant (37, 39) conformé et dimensionné pour autoriser le passage du collier de serrage autobloquant, ledit boîtier étant adapté pour être fixé au câble d'alimentation électrique par bouclage du collier de serrage autobloquant autour du câble d'alimentation électrique en passant par ledit trou traversant, ou
- au moins une portion (41, 43) faisant saillie du boîtier, ledit boîtier étant adapté pour être fixé au câble d'alimentation électrique par bouclage du collier de serrage autobloquant autour du câble d'alimentation électrique et de ladite portion.

7. Système selon la revendication 5 ou 6, dans lequel les moyens d'attache comprennent un élastique (45) et dans lequel le boîtier présente une ou plusieurs paires de crochets (47, 49, 51) agencés sur des faces latérales opposées dudit boîtier, ledit boîtier étant adapté pour être fixé au câble d'alimentation électrique par rappel dudit élastique accroché audit boîtier via ladite paire de crochets, ledit boîtier et ledit élastique enserrant ainsi le câble d'alimentation électrique.

8. Système selon l'une des revendications précédentes, comprenant en outre un témoin visuel (29) représentatif de l'intensité du champ magnétique mesurée par le capteur de champ magnétique.

9. Procédé d'estimation de consommation d'un chauffe-eau (1) électrique à accumulation mis en oeuvre par le système (3) selon l'une des revendications précédentes et comprenant :
- mesurer (S2), par le capteur de température (17), la température au niveau du tuyau (11) d'extraction d'eau chaude,
- mesurer (S3), par le capteur de champ magnétique (21), une intensité du champ magnétique au niveau du câble (13) d'alimentation électrique,
ledit procédé comprenant en outre les étapes suivantes mises en oeuvre par le circuit de traitement (23) dudit système :
- détecter (S4), en fonction des mesures du capteur de champ magnétique, une ou plusieurs périodes de chauffe du chauffe-eau, puis estimer, en fonction de la ou des périodes de chauffe détectées et de caractéristiques électriques du chauffe-eau, une consommation électrique du chauffe-eau sur une période de temps donnée, et
- détecter (S6), en fonction des mesures du capteur de température, un ou plusieurs soutirages d'eau chaude du chauffe-eau, classifier le ou les soutirages d'eau chaude, en fonction d'une évolution temporelle des températures mesurées par le capteur de température entre le début et la fin du soutirage, puis estimer, en fonction du ou des soutirages d'eau chaude détectés et de la classe du ou des soutirages, une quantité d'eau chaude soutirée sur ladite période de temps.

10. Procédé selon la revendication 9, comprenant en outre : estimer (S5), en fonction de la consommation électrique, de caractéristiques thermiques, du volume et d'une consigne de température du chauffe-eau, une quantité d'eau chaude produite sur ladite période de temps.

11. Procédé selon la revendication 9 ou 10, dans lequel les caractéristiques électriques comprennent au moins une puissance électrique nominale du chauffe-eau.

12. Procédé selon l'une des revendications 9 à 11, dans lequel le système comprend un témoin visuel (29) représentatif de l'intensité du champ magnétique mesurée par le capteur de champ magnétique, comprenant en outre une étape (S1) préalable de positionnement, à l'aide du témoin visuel, du capteur de champ magnétique à proximité d'une position correspondant à une intensité du champ magnétique supérieure à une intensité minimale ou inférieure à une intensité maximale.

13. Procédé selon l'une des revendications 9 à 12, dans lequel le circuit de traitement est localisé au niveau d'un serveur distant et dans lequel le système comprend en outre un module de communication (27),
ledit procédé comprenant en outre : transmettre, via le module de communication, les mesures collectées par les capteurs au circuit de traitement.

14. Procédé selon l'une des revendications 9 à 13, comprenant en outre :
- bloquer (S10) toute chauffe du chauffe-eau lorsque la consommation électrique du chauffe-eau est supérieure à un seuil de consommation électrique prédéterminé sur ladite période de temps, ou
- autoriser (S10) une chauffe du chauffe-eau lorsqu'une quantité d'eau chaude restante, estimée en fonction de la quantité d'eau chaude soutirée estimée, est inférieure à un seuil de quantité d'eau chaude prédéterminé.

15. Programme informatique comprenant des instructions pour la mise en oeuvre des étapes du procédé selon l'une des revendications 9 à 14 par le système selon l'une quelconque des revendications 1 à 8, lorsque lesdites instructions sont exécutées par un processeur dudit système.

## Patentansprüche

1. System (3) zum Schätzen eines Verbrauchs eines elektrischen Warmwasser-Speichers (1),
wobei das System umfasst:
- einen Temperatursensor (17), welcher dazu angeordnet ist, die Temperatur an einer Entnahmeleitung (11) für heißes Wasser aus einem Speichertank (7) des Warmwasser-Speichers zu messen, und dazu eingerichtet ist, eine Temperaturvariation zu messen, welche durch die Zirkulation des heißen Wassers ausgelöst wird,
- einen Magnetfeldsensor (21), welcher dazu angeordnet ist, eine Magnetfeldstärke auf einem elektrischen Versorgungskabel (13) des Warmwasser-Speichers zu messen, und
- eine Verarbeitungsschaltung (23), welche dazu eingerichtet ist:
als Funktion von Messungen des Magnetfeldsensors eine oder mehrere Erhitzungsperioden des Warmwasser-Speichers zu detektieren und dann als Funktion der einen oder der mehreren detektierten Heizperioden und elektrischen Charakteristiken des Warmwasser-Speichers einen elektrischen Verbrauch des Warmwasser-Speichers während einer vorgegebenen Zeitperiode zu schätzen, und als Funktion von Messungen des Temperatursensors eine oder mehrere Entnahmen von heißem Wasser aus dem Warmwasser-Speicher zu detektieren, die eine oder die mehreren Entnahmen von heißem Wasser zu klassifizieren, als Funktion einer zeitlichen Entwicklung der Temperaturen, welche durch den Temperatursensor zwischen dem Beginn und dem Ende der Entnahme gemessen werden, und dann als Funktion der einen oder der mehreren detektierten Entnahmen von heißem Wasser und der Klasse der einen oder der mehreren Entnahmen eine während der Zeitperiode entnommene Menge an heißem Wasser zu schätzen.

2. System nach Anspruch 1, ferner umfassend einen weiteren Temperatursensor (19), welcher dazu angeordnet ist, die Temperatur an einer Versorgungsleitung (9) für kaltes Wasser in den Speichertank des Warmwasser-Speichers zu messen, und dazu eingerichtet ist, eine Temperaturvariation zu messen, welche durch die Zirkulation des kalten Wassers ausgelöst wird,
wobei die Verarbeitungsschaltung dazu eingerichtet ist, eine oder mehrere Entnahmen von heißem Wasser aus dem Warmwasser-Speicher ferner als Funktion von Messungen des weiteren Temperatursensors zu detektieren.

3. System nach Anspruch 1 oder 2, wobei einer oder mehrere der Sensoren dazu eingerichtet sind, Messungen in regelmäßigen Zeitintervallen aufzunehmen.

4. System nach einem der vorhergehenden Ansprüche, ferner umfassend ein Kommunikationsmodul (27), welches dazu eingerichtet ist, die von den Sensoren vorgenommenen Messungen zu der Verarbeitungsschaltung zu übertragen, wobei die Verarbeitungsschaltung auf der Ebene eines entfernten Servers angeordnet ist.

5. System nach einem der vorhergehenden Ansprüche, wobei der Magnetfeldsensor in einem Gehäuse (25) untergebracht ist, welches Anbringungsmittel für ein Befestigen an dem elektrischen Versorgungskabel umfasst.

6. System nach Anspruch 5, wobei die Anbringungsmittel eine selbstblockierende Schelle (33, 35) umfassen, und wobei das Gehäuse aufweist:
- ein Durchgangsloch (37, 39), welches dazu geformt und bemessen ist, den Durchgang der selbstblockierenden Schelle zu ermöglichen, wobei das Gehäuse dazu eingerichtet ist, an dem elektrischen Versorgungskabel durch Ringbildung der selbstblockierenden Schelle um das elektrische Versorgungskabel herum befestigt zu sein, indem sie durch das Durchgangsloch hindurchtritt, oder
- wenigstens einen Abschnitt (41, 43), welcher von dem Gehäuse vorsteht, wobei das Gehäuse dazu eingerichtet ist, an dem elektrischen Versorgungskabel durch Ringbildung der selbstblockierenden Schelle um das elektrische Versorgungskabel und den Abschnitt herum befestigt zu sein.

7. System nach Anspruch 5 oder 6, wobei die Anbringungsmittel ein elastisches Element (45) umfassen, und wobei das Gehäuse ein oder mehrere Paare von Haken (47, 49, 51) aufweist, welche an gegenüberliegenden Seitenflächen des Gehäuses bereitgestellt sind, wobei das Gehäuse dazu eingerichtet ist, an dem elektrischen Versorgungskabel durch eine Rückstellkraft des elastischen Elements befestigt zu sein, welches an das Gehäuse mittels des Paars von Haken gekoppelt ist, wobei das Gehäuse und das elastische Element folglich das elektrische Versorgungskabel umschließen.

8. System nach einem der vorhergehenden Ansprüche, ferner umfassend eine visuelle Anzeige (29), welche die Magnetfeldstärke repräsentiert, welche von dem Magnetfeldsensor gemessen wird.

9. Verfahren zum Schätzen eines Verbrauchs eines elektrischen Warmwasser-Speichers (1), welches durch das System (3) nach einem der vorhergehenden Ansprüche durchgeführt wird und umfasst:
- Messen (S2), durch den Temperatursensor (17), der Temperatur an der Entnahmeleitung (11) für heißes Wasser,
- Messen (S3), durch den Magnetfeldsensor (21), einer Magnetfeldstärke an dem elektrischen Versorgungskabel (13),
wobei das Verfahren ferner die folgenden Schritte umfasst, welche durch die Verarbeitungsschaltung (23) des Systems durchgeführt werden:
- Detektieren (S4), als Funktion von Messungen des Magnetfeldsensors, einer oder mehrerer Erhitzungsperioden des Warmwasser-Speichers, und dann Schätzen, als Funktion der einen oder der mehreren detektierten Erhitzungsperioden und elektrischen Charakteristiken des Warmwasser-Speichers, eines elektrischen Verbrauch des Warmwasser-Speichers während einer vorgegebenen Zeitperiode, und
- Detektieren (S6), als Funktion von Messungen des Temperatursensors, von einer oder mehreren Entnahmen von heißem Wasser aus dem Warmwasser-Speicher, Klassifizieren der einen oder der mehreren Entnahmen von heißem Wasser als Funktion einer zeitlichen Entwicklung der Temperaturen, welche durch den Temperatursensor zwischen dem Beginn und dem Ende der Entnahme gemessen werden, und dann Schätzen, als Funktion der einen oder der mehreren detektierten Entnahmen von heißem Wasser und der Klasse der einen oder der mehreren Entnahmen, einer während der Zeitperiode entnommenen Menge an heißem Wasser.

10. Verfahren nach Anspruch 9, ferner umfassend:
Schätzen (S5), als Funktion des elektrischen Verbrauchs, von thermischen Charakteristiken, des Volumens und eines Temperatur-Sollwerts des Warmwasser-Speichers, einer während der Zeitperiode erzeugten Menge an heißem Wasser.

11. Verfahren nach einem der Ansprüche 9 oder 10, wobei die elektrischen Charakteristiken wenigstens eine nominelle elektrische Leistung des Warmwasser-Speichers umfassen.

12. Verfahren nach einem der Ansprüche 9 bis 11, wobei das System eine visuelle Anzeige (29) umfasst, welche die Magnetfeldstärke repräsentiert, welche durch den Magnetfeldsensor gemessen wird, ferner umfassend einen vorhergehenden Schritt (S1) eines Positionierens, mit Hilfe der visuellen Anzeige, des Magnetfeldsensors in der Nähe einer Position, welche einer Magnetfeldstärke entspricht, welche größer als eine minimale Stärke oder kleiner als eine maximale Stärke ist.

13. Verfahren nach einem der Ansprüche 9 bis 12, wobei die Verarbeitungsschaltung auf der Ebene eines entfernten Servers angeordnet ist und wobei das System ferner ein Kommunikationsmodul (27) umfasst,
wobei das Verfahren ferner umfasst: Übertragen, mittels des Kommunikationsmoduls, von Messungen, welche durch die Sensoren aufgenommen werden, zu der Verarbeitungsschaltung.

14. Verfahren nach einem der Ansprüche 9 bis 13, ferner umfassend:
- Blockieren (S10) jeder Erhitzung des Warmwasser-Speichers, wenn der elektrische Verbrauch des Warmwasser-Speichers größer als ein vorbestimmter elektrischer Verbrauch-Schwellenwert während der Zeitperiode ist, oder
- Erlauben (S10) einer Erhitzung des Warmwasser-Speichers, wenn eine verbleibende Menge an heißem Wasser, welche als Funktion der geschätzten entnommenen Menge an heißem Wasser geschätzt wird, kleiner als ein vorbestimmter Schwellenwert einer Menge an heißem Wasser ist.

15. Computerprogramm, umfassend Anweisungen für das Ausführen der Schritte des Verfahrens nach einem der Ansprüche 9 bis 14 durch das System nach einem der Ansprüche 1 bis 8, wenn die Anweisungen durch einen Prozessor des Systems ausgeführt werden.

## Claims

1. System (3) estimating consumption of an accumulation electric water heater (1), said system comprising:
- a temperature sensor (17) arranged to measure the temperature at a pipe (11) for extracting hot water from a storage tank (7) of said water heater and able to measure a variation in temperature caused by the circulation of the hot water,
- a magnetic-field sensor (21) arranged to measure an intensity of the magnetic field at an electrical supply cable (13) of said water heater, and
- a processing circuit (23) configured to:
detect, according to the measurements of the magnetic-field sensor, one or more heating periods of the water heater, and then estimate, according to the heating period or periods detected and electrical characteristics of the water heater, an electrical consumption of the water heater over a given period of time, and detect, according to the measurements of the temperature sensor, one or more extractions of hot water from the water heater, classify the extraction or extractions of hot water, according to a change over time in the temperatures measured by the temperature sensor between the start and end of the extraction, and then estimate, according to the extraction or extractions of hot water detected and the class of the extraction or extractions, a quantity of hot water extracted over said period of time.

2. System according to claim 1, further comprising an additional temperature sensor (19) arranged to measure the temperature at a pipe (9) supplying cold water to the storage tank of the water heater and able to measure a variation in temperature caused by the circulation of the cold water,
the processing circuit being configured to detect one or more extractions of hot water from the water heater according furthermore to the measurements of the additional temperature sensor.

3. System according to claim 1 or 2, wherein one or more of the sensors are configured to collect measurements at regular intervals of time.

4. System according to one of the preceding claims, further comprising a communication module (27) configured to transmit the measurements made by the sensors to the processing circuit, said processing circuit being located at a remote server.

5. System according to one of the preceding claims, wherein the magnetic-field sensor is housed in a casing (25) comprising attachment means for being secured to the electrical supply cable.

6. System according to claim 5, wherein the attachment means comprise a self-locking clamping collar (33, 35) and wherein the casing has:
- a through hole (37, 39) conformed and sized so as to enable the self-locking clamping collar to pass, said casing being adapted to be secured to the electrical supply cable by looping of the self-locking clamping collar around the electrical supply cable and passing through said through hole, or
- at least one portion (41, 43) projecting from the casing, said casing being adapted to be secured to the electrical supply cable by looping of the self-locking clamping collar around the electrical supply cable and said portion.

7. System according to claim 5 or 6, wherein the attachment means comprise an elastic (45) and wherein the casing has one or more pairs of hooks (47, 49, 51) arranged on opposite lateral faces of said casing, said casing being adapted to be secured to the electrical supply cable by return of said elastic attached to said casing via said pair of hooks, said casing and said elastic thus gripping the electrical supply cable.

8. System according to one of the preceding claims, further comprising a visual indicator (29) representing the intensity of the magnetic field measured by the magnetic-field sensor.

9. Method for estimating consumption of an accumulation electric water heater (1) implemented by the system (3) according to one of the preceding claims and comprising:
- measuring (S2), by the temperature sensor (17), the temperature at the hot-water extraction pipe (11),
- measuring (S3), by the magnetic-field sensor (21), an intensity of the magnetic field at the electrical supply cable (13),
said method further comprising the following steps implemented by the processing circuit (23) of said system:
- detecting (S4), according to the measurements of the magnetic-field sensor, one or more heating periods of the water heater, and then estimating, according to the heating period or periods detected and electrical characteristics of the water heater, an electrical consumption of the water heater over a given period of time, and
- detecting (S6), according to the measurements of the temperature sensor, one or more extractions of hot water from the water heater, classifying the hot-water extraction or extractions according to a change over time in the temperatures measured by the temperature sensor between the start and end of the extraction, and then estimating, according to the hot-water extraction or extractions detected and the class of the extraction or extractions, a quantity of hot water extracted over said period of time.

10. Method according to claim 9, further comprising: estimating (S5), according to the electrical consumption, to thermal characteristics, to the volume and to a set temperature point of the water heater, a quantity of hot water produced over said period of time.

11. Method according to claim 9 or 10, wherein the electrical characteristics comprise at least one nominal electrical power of the water heater.

12. Method according to one of claims 9 to 11, wherein the system comprises a visual indicator (29) representing the intensity of the magnetic field measured by the magnetic-field sensor, further comprising a prior step (S 1) of positioning, by means of the visual indicator, the magnetic-field sensor in proximity to a position corresponding to an intensity of the magnetic field greater than a minimum intensity or less than a maximum intensity.

13. Method according to one of claims 9 to 12, wherein the processing circuit is located at a remote server and wherein the system further comprises a communication module (27),
said method further comprising: transmitting to the processing circuit, via the communication module, the measurements collected by the sensors.

14. Method according to one of claims 9 to 13, further comprising:
- blocking (S10) any heating of the water heater when the electrical consumption of the water heater is above a predetermined electrical-consumption threshold over said period of time, or
- enabling (S10) a heating of the water heater when a remaining quantity of hot water, estimated according to the estimated quantity of hot water extracted, is below a predetermined hot-water quantity threshold.

15. Computer program comprising instructions for implementing the steps of the method according to one of claims 9 to 14 by the system according to any one of claims 1 to 8, when said instructions are executed by a processor of said system.
